# EUROPEAN PATENT APPLICATION

(11) **EP 1 901 363 A1**
(43) Date of publication of application: **19.03.2008**
(21) Application number: 06746376.0
(22) Date of filing: 15.05.2006
(51) Int. Cl.: H01L 51/00, C09K 11/06

(54) **LUMINESCENT DEVICE AND ELECTROLUMINESCENCE UTILIZING THE SAME**

(30) Priority: 27.05.2005 JP 2005155911
(71) Applicant: Gifu University, Gifu-shi Gifu 501-1193 (JP); CENTRE NATIONAL DE LA RECHERCHE SCIENTIFIQUE (CNRS), 75794 Paris Cedex 16 (FR)
(72) Inventor: Yoshida, Tsukasa, Gifu-shi, Gifu 5011193 (JP); Minoura, Hideki, Gifu-shi, Gifu 5011193 (JP); Komatsu, Daisuke, Gifu-shi, Gifu 5011193 (JP); Pauporte, Thierry, Paris Cedex 16, 75794 (FR); Lincot, Daniel, Paris Cedex 16, F-75794 (FR)
(74) Representative: Maillet, Alain
(86) International application number: PCT/JP2006/309629
(87) International publication number: WO 2006/126407

(57) **Abstract**

[Object] To provide a hybrid luminescent device having a novel structure where a rare earth metal complex is used in a luminescent layer and an inorganic compound is used in an electron transport layer or a hole transport layer instead of an organic compound.

[Means for Achieving the Object] In order to cathodic polarize a thin film of crystalline porous zinc oxide from a zinc salt solution, a ligand having a moiety which can be coordinated with the surface of zinc oxide and a moiety which is used for the formation of a complex with rare earth ions in a later process is mixed into an electrolytic bath so that a hybrid film of crystalline porous zinc oxide/ligands is obtained through cathodic polymerization. Alternatively, a template molecule for the formation of a porous structure may be mixed into an electrolytic bath of a zinc salt solution so that a thin film of crystalline porous zinc oxide is gained through cathodic polarization, and after that, this may be immersed in a solution of bridge ligands as that described above so that crystalline porous zinc oxide of which the surface is modified with bridge ligands in the same manner is fabricated. The thin film is immersed in a solution in which rare metal ions are dissolved, and thus, a complex is formed to obtain a luminescent device.

## Description

### Technical Field

The present invention relates to a luminescent device made of a metal complex where crystalline porous zinc oxide is modified with a bridge ligand and a rare earth metal, as well as electroluminescence (hereinafter referred to as "EL") using this luminescent device.

### Background Art

A variety of research has been conducted in order to implement an organic EL element since an organic EL element having a multilayer structure of an organic compound was developed by a group with C. W. Tang with Eastman Kodak Company as a luminescent device used for displays or the like.

However, there are still many problems with implementation of organic EL in products, and in particular, an urgent problem to be solved regarding the present organic EL is how to make the life long. The following points have become specific problems as factors which prevent organic EL from having a long life.

First, there is a problem of the deterioration of organic EL layers caused by oxygen. There is a possibility that the electron transport layer and the hole transport layer using an organic material may be oxidized when there exists oxygen in the system during the process in which these layers are formed as a film or electrodes are formed as a film, and thus, oxidation may be occurred to the electron transport layer and the hole transport layer, and its performance as organic EL layers may be deteriorated.

Concerning this point, for example, an organic EL element where a buffer layer is provided between an organic EL layer and electrodes for the purpose of reducing damage to the organic layer when the electrodes are formed is disclosed (Patent Document 1).

Next, there is a problem with water. This includes cases where water adsorbed on the surface of the components of an organic EL element or water that penetrates into an organic EL element causes a reaction with or denatures organic molecules in the electron transport layer or the hole transport layer in the interface with electrodes which are in an activated state and water penetrates into the multilayer body of electrodes and organic layers, causing peeling off between electrodes and organic layers, and thus, dark spots are created, due to the failure of energization.

As a technology for improving organic EL elements in terms of this point, for example, a technology for sealing an organic EL element with a sealing member and providing a moisture absorbent inside the sealing member has been developed, in order to lower the humidity inside the organic EL element (Patent Document 2 and the like).

According to the technologies for solving these problems, however, resistance to oxidation and resistance to water are not secured for the organic EL element itself, and that does not mean that the defects of the organic EL element are not eliminated, but that oxygen and water which cause these problems are merely blocked, and thus, the technologies do not provide any means for solving the problems from the root.
Patent Document 1: Japanese Unexamined Patent Publication H10 (1998)-162959
Patent Document 2: Japanese Unexamined Patent Publication H09 (1997)-148066

### Disclosure of the Invention

### Problem to Be Solved by the Invention

The present invention provides a hybrid type luminescent device having a new configuration, where molecules of a rare earth metal complex are used as the center of luminescence and an inorganic compound is used in the electron transport layer or the hole transport layer instead of an organic compound, and thus, provides a luminescent device having this configuration, which is strong against oxidation and water, as well as EL, using this luminescent device.

### Means for Solving Problem

In order to solve the above described problems, the present inventors found that ligands having a moiety which can be coordinated on the surface of zinc oxide and a moiety used for the formation of a complex with a rare earth ion in a later process (referred to as "bridge ligands" in the present specification and claims) can be mixed into a electrolytic bath, namely, a zinc salt solution when a thin film of crystalline porous zinc oxide is cathodically electrodeposited in a zinc salt solution, so that a hybrid film of crystalline porous zinc oxide/ligand is obtained as a result of cathodic polarization, and after that, this can be immersed in the above described bridge ligand solution so that crystalline porous zinc oxide of which the surface is modified with bridge ligands in the same manner is fabricated, and when these thin films are immersed in a solution in which rare earth metal ions are dissolved, a luminescent complex can be easily formed, and thus, completed the present invention.

The luminescent device according to the present invention is characterized by being formed of a matrix having crystalline porous zinc oxide as a main component and a luminescent element made of a metal complex formed on the surface of the above described matrix of a modified bridge ligand and a rare earth metal. That is to say, the crystalline porous zinc oxide, which is an inorganic compound, functions as an electron transport layer, and the rare earth metal complex functions as a luminescent layer.

According to the present invention, crystalline porous zinc oxide is used as the matrix. As the crystalline porous zinc oxide, zinc oxide which is electrolytically deposited on a conductive substrate by cathodically polarizing the conductive substrate in an electrolytic solution where zinc halide, for example zinc chloride, is dissolved in water and oxygen is dissolved or an electrolytic solution containing a zinc salt, where zinc nitrate and zinc perchlorate having electrochemical reduction properties are dissolved in water, can be cited. Generation of zinc oxide as a result of reaction between OH⁻ ions and zinc ions generated through reduction of dissolved oxygen and reduction of nitrate ions and perchlorate ions is used. Preferably, crystalline porous zinc oxide obtained by cathodically polarizing a conductive substrate in an electrolytic solution containing a zinc salt into which a template compound having adsorptivity for zinc oxide is mixed so that a zinc oxide/template molecule hybrid is deposited on the conductive substrate, and after that, removing the template molecules from this zinc oxide/template molecule hybrid may be used. This is because the fabricated zinc oxide, where zinc oxide crystals having a size of several micrometers are formed throughout the entirety in such a manner that wires of zinc oxide are linked to each other in a regular pattern, has three-dimensional nano-pores, and thus, a high specific surface area, as well as the high crystallinity required for electron transport, and thus, is excellent in terms of the adsorptivity of the ligands and functionality as an electron transport layer.

The surface of this crystalline porous zinc oxide is modified with bridge ligands. The bridge ligands have effects of bridging the rare earth metal with the zinc oxide, and at the same time, form a metal complex with the rare earth metal so as to play a role in forming a luminescent material. It is preferable for organic molecules having two or more types of moieties which can be coordinated with a metal ion in one molecule to be used as the bridge ligand, so that the bridge ligand can form a coordinated compound where the location of the moieties can be selected on the basis of the type of rare earth metal ion with which the bridge ligand is coordinated. Preferably, at least one selected from a β-diketone group shown in the general formula R¹COCR²COR³, wherein R² and R³ represent an alkyl group with a carbon number of 1-20, a halogenated alkyl group with a carbon number of 1-20, an aryl group with a carbon number of 6-20, a 5 or 6-member heterocyclic group having one hetero atom or a carboxyl group, and R² represents a hydrogen atom, a halogen atom, a cyano group, an alkyl group with a carbon number of 1-20, a halogenated alkyl group with a carbon number of 1-20, an aryl group with a carbon number of 6-20 or a 5 or 6-member heterocyclic group having one hetero atom is used. More preferably, one or more types selected from the group consisting of 2,2'-bipyridine 4,4-dicarboxylic acid (hereinafter referred to as "dcbpy"), phenanthroline, 1, 10-phenanthxoline-4,7-dicarboxylic acid, 2,2';6',2"-terpyridine-4'-carbonxylic acid, 2,2';6',2"-terpyridine, 4,4',4"-tricarboxylic acid, 2,2'-biquinoline-4,4' dicarboxylic acid, 4-quinolinecarboxylic acid, 2-(4-carboxy-2-pyridinyl) and dibenzo [b,j] [1,10] phenanthroline-5,6-dicarboxylic acid is used.

As the rare earth metal, lanthanoid series elements; Sc, Y, La, Ce, Pr, Nd, Pm, Sm, Eu, Gd, Tb, Dy, Ho, Er, Tm, Yb and Lu, can be cited. Preferably, Eu, Tb, Tm or Ce, which exhibit light emission of red, green and blue, respectively, is used.

The present invention can provide a luminescent device for photoluminescence having little deterioration, which is achieved as a result of energy transformation from the ligand to the rare earth ion, where the rare earth metal complex, which adsorbs water in the air so as to easily decompose, is stabilized by the bridge ligand.

Furthermore, in the luminescent device of the present invention, the surface of the rare earth complex can be capped with a ligand which forms a complex with a rare earth metal. The capping ligand is a ligand which forms a complex with a rare earth metal adsorbed by a bridge ligand, thus making the rare earth metal complex stable. By the capping process, the complex of the rare earth metal is stabilized, and the intensity of luminescence is increased. In addition, the resistance to water can be increased.

As the capping ligand, a ligand having one or more moieties which can be coordinated may be used. For example, at least one selected from a β-diketone group shown in the general formula R¹COCR²COR³, wherein R¹ and R³ represent an alkyl group with a carbon number of 1-20, a halogenated alkyl group with a carbon number of 1-20, an aryl group with a carbon number of 6-20, a 5 or 6-member heterocyclic group having one hetero atom or a carboxyl group, and R² represents a hydrogen atom, a halogen atom, a cyano group, an alkyl group with a carbon number of 1-20, a halogenated alkyl group with a carbon number of 1-20, an aryl group with a carbon number of 6-20 or a 5 or 6-member heterocyclic group having one hetero atom may be used. Preferably, one or more types selected from the group consisting of 4,9,9-trifluoro-1-(2-thienyl)-1,3-butanedione, 1,10-phenanthroline and derivatives of these, 2,2'-bipyridine and derivatives thereof, 2,2';6',2"-terpyridine and derivatives thereof, and combinations of these are used.

EL can be achieved by applying a luminescent device having the above described configuration. Concretely, an N type semiconductor having a thin film of crystalline porous zinc as a main component is fabricated, this N type semiconductor is used for an electron transport layer for EL, a metal complex formed of a bridge ligand and a rare earth metal is used for the luminescent layer, and a P type semiconductor fabricated from an inorganic compound is used as a hole transport layer for EL, and each of these are layered on top of each other, and an electrode layer is provided on the two outer layers of the multilayer body, so that EL is achieved.

A hole transport layer is provided in the above described luminescent device in order to achieve EL. As the hole transport layer, an inorganic compound which is a substance which functions as a P type semiconductor is selected. For example, one or more types selected from CuI, CuSCN, NiO and Cu₂O can be used.

Furthermore, according to the present invention, though the EL does not need to be provided with a capping layer, more stable EL can be made in the case where capping is provided between the luminescent layer and the hole transport layer through a capping ligand which forms a complex with a rare earth metal. The same ligands as that used in the above described luminescent device can be used as the capping ligands.

The material for the electrode layers is not particularly limited, and various electrodes that have been proposed in the prior art can be used. ITO, FTO, Au, Pt, Ag, Al, C, ITO and the like can be cited as examples of the electrodes but are not limited to these. Appropriate materials may be selected for the cathode and the anode taking the conditions, for example the work function, into consideration, as long as either the anode or the cathode is a transparent electrode; that is, on the basis of whether the device is of a top emission type or a bottom emission type. Preferably, ITO or FTO is adopted for the cathode.

Furthermore, a substrate can be provided as at least one outer layer of the electrode. Glass or a transparent thermoplastic resin is used as the substrate. The EL of the present invention is strong against oxygen and water, and therefore, does not require barrier properties as high as those of glass against outside air. In addition, all of the materials can be formed at a temperature of as low as 100 °C or lower on the basis of chemical or electrochemical principles, and therefore, it is not necessary for the substrate to be resistant to heat. Thus, according to the present invention, the substrate may simply play a role as a support for the luminescent device, and no problem arises, even when a plastic including a thermoplastic resin having low barrier properties which cannot stand high temperatures is adopted.

### Effects of the Invention

According to the present invention, a luminescent device using a complex of a rare earth metal for the luminescent layer can be fabricated by grafting it on an inorganic compound. In addition, it can be fabricated using a low molecular luminescent substance through immersion or polarization instead of vapor deposition, and therefore, the luminescent device can be provided at a temperature of as low as 100 °C or lower. Accordingly, a lightweight and flexible luminescent device which is difficult to crack can be provided.

In addition, fabrication is possible without adopting a vacuum process, which can contribute to reduction of the cost for fabrication. Furthermore, the main process for the fabrication of the EL element is immersion or polarization in a solution, and therefore, no compound which is not used for the formation of a thin film is vapor deposited, unlike in the vacuum process. According to the present invention, basically only one type of disposal; a process for waste fluid, is necessary, and therefore, the cost for disposal can be reduced, which can also contribute to reduction in the cost of fabrication, from this point of view.

In addition, according to the present invention, a rare earth metal complex is used as the center of luminescence, and therefore, luminescence of various colors can be achieved, by changing the rare earth metal or mixing rare earth metals. In addition, the rare earth metal complex and the zinc oxide, which is the matrix, do not absorb visible light, and therefore, are colorless, and thus, a luminescent device having excellent color rendering properties can be provided.

In addition, a luminescent device which is strong against water and oxidation despite using a rare earth metal complex in the luminescent layer can be provided.

Furthermore, EL can be easily achieved by applying the luminescent device in such a manner that an N type semiconductor having a thin film of crystalline porous zinc as a main component is fabricated and used as an electron transport layer, a metal complex formed with a bridge ligand and a rare earth metal is used as a luminescent layer, a P type semiconductor fabricated from an inorganic compound is used as a hole transport layer for EL, and each of these are layered on top of each other, and an electrode layer is provided on the two outer layers of the multilayer body. Best Mode for Carrying Out the Invention

Next, the luminescent device and EL for which this electroluminescent device is applied according to the preferred embodiments of the present invention are shown, but the present invention is not limited to the following embodiments.

(1) Electrochemical fabrication of thin film of crystalline porous zinc oxide

(a) Method 1

A transparent conductive substrate where a thin film of transparent conductive ceramics, such as tin oxide doped indium oxide (ITO) or fluorine doped tin oxide (FTO), is formed on a transparent glass plate is used as a conductive substrate. In addition, it is not necessary to sinter crystalline porous zinc oxide at a high temperature, and no chemical having high reactivity, such as a strong acid or a strong base, is used, and therefore, transparent plastic, for example a PET resin, where an ITO film is formed on the surface, may be used as a substrate.

It is preferable to clean the conductive substrate so as to remove oil, and carry out a process for activating the surface before use. As the process for activation, for example, a method for activation for oxidoreduction through surface hydrophilization through immersion of the conductive substrate in a solution of approximately 45 % nitric acid for 2 to 3 minutes and a method for activating the substrate through continuous oxidation-reduction reaction by cathodically polarizing the substrate at approximately -1.0 V (_{vs.}SCE = saturated calomel electrode) using a precious metal such as Pt, for the counter electrode in a KCl solution which does not include a zinc salt can be cited as examples. The method for activation is, of course, not limited to these.

A thin film of crystalline zinc oxide can be obtained by cathodically polarizing the conductive substrate in such a state that oxygen is dissolved in a zinc salt solution through which an oxygen gas passes at a temperature of no lower than 30°C, preferably no lower than 50 °C, more preferably at a temperature between 60 °C and 80 °C. A zinc halide, for example zinc chloride or zinc nitrate, zinc perchlorate or the like can be used as a zinc salt. Though water is mainly used as the solvent, a protic solvent such as alcohol, a non-protic polar solvent such as dimethyl sulfoxide, dimethyl formamide, acetonitrile or propylene carbonate, or a mixed solvent can also be used. Here, in the case where the concentration of the zinc salt is sufficiently high (approximately 50 mM or higher), it is possible for the material to include only a zinc salt, but in the case where it is low, an appropriate amount of support electrolyte is added, and thus, the low conductivity of the solution is made up for. In the case where a zinc halide is used as the material, oxygen is made to pass through the solution so as to dissolve. In the case of a salt other than this, the whole may be placed in a vacuum, or the conditions may allow for there to be oxygen, for example, the whole may be placed in the condition that air exists.

Crystalline porous zinc oxide is generated when OH⁻ ions are generated in the vicinity of an electrode through reduction of dissolved oxygen, or reduction of nitric ions or perchloric ions so that the generated OH⁻ ions react with zinc ions so as to be dehydrated. Here, in addition to this, a substance which generates hydroxide ions when electrochemically reduced, or where protons are consumed in a reduction reaction, such as hydrogen peroxide, benzoquinone, nitrous acid, chloric acid, bromic acid or iodic acid, can be used.

(b) Method 2

According to the present invention, zinc oxide deposited by cathodically polarizing a conductive substrate in an electrolytic solution containing a zinc salt into which a template compound having adsorptivity for zinc oxide is mixed so that a zinc oxide/template molecule hybrid is deposited on the conductive substrate, and after that, removing the template molecules from the zinc oxide/template molecule hybrid. In the following, a method for forming this zinc oxide thin film is described.

Here, template compound means a compound which is adsorbed on the internal surface of porous zinc oxide formed through cathodic polarization. The template compound may be a compound which does not exist inside the bulk of zinc oxide as a result of chemical adsorption but is adsorbed on the internal surface of porous zinc oxide through formation of a complex with zinc ions. Such compounds have electrochemical reducing properties and are reduced during the process of growth of a thin film of zinc oxide so as to increase the nucleophilicity, an thus, forms a complex with zinc ions, and this is adsorbed on the internal surface of porous zinc oxide crystal, and therefore, the compound prevents the crystal from growing further and creates nano-pores inside the crystal particles in such a manner that the nano-pores have the size of the molecules of the template compound + α and are connected three-dimensionally. Composites having π-electrons such as aromatic composites having an anchor group, a carboxyl group, a sulfonic acid group or a phosphoric acid group, and electrochemical reducing properties, are preferable, and concrete examples are the following.

There are Eosin Y, fluorescein, erythrosine B, phloxine B, rose bengal, fluorexon, mercurochrome, dibromofluorescein, pyrogallol red and the like, which are xanthene based dyes, coumarin 343 and the like which are coumarin based dyes, bromophenol blue, bromothymol blue, phenolphthalein and the like, which are triphenyl methane based dyes. In addition to these, cyanine based dyes, merocyanine based dyes, porphyrin, phthalocyanine, perylene tetracarboxylic acid derivatives, indigo dyes, oxonol dyes, anthocyanine, gardenia dyes, turmeric dyes, safflower dyes, carotenoid dyes, cochineal dyes, paprika dyes, which are natural dyes; and polypyridine complexes such as of Ru and Os can be cited. In addition to the above, it is possible to use other surfactants, such as sodium dodecyl sulfonate, sodium hexdecyl sulfonate, sodium dodecyl phosphate and sodium hexdecyl phosphate.

Cathodic polarization for the formation of a thin film of zinc oxide is carried out in an electrolytic bath containing a zinc salt where there is a desired substrate. A zinc halide such as zinc chloride, zinc bromide or zinc iodide, or zinc nitride, zinc perchlorate or the like can be used as the zinc salt, and in the case of using a zinc halide, oxygen is supplied (through bubbling), because the dye is oxidized, making desorption impossible in the case where the bubbles of oxygen make contact with the electrode, it is necessary to provide a means for preventing the electrode from making contact with bubbles. As the counter electrode, in the case where a zinc salt is used, zinc, gold, platinum, carbon and the like can be used, and use of zinc is particularly convenient, because zinc for consumption through the formation of zinc oxide can be supplied, and at the same time, the PH of the solution can be prevented from lowering. A regular thin film structure can be obtained in the zinc oxide as a result of cathodic polarization, and in addition, heat treatment is unnecessary, unlike in the case of using titanium oxide, and therefore, the range of selection in terms of the substrate becomes wider. A hybrid thin film of zinc oxide and template molecules is obtained as a thin film of porous zinc oxide through cathodic polarization in the above described electrolytic bath into which a template compound is mixed in advance. Furthermore, a template compound adsorbed on the internal surface of a thin film of porous zinc oxide can be obtained by providing a means for desorption. Because of this, the template compound is removed from the surface of the thin film of zinc oxide, and a great number of voids are created, so that a film of zinc oxide which is highly porous and has a great specific surface area can be obtained. The template compound can be cleaned off using a basic solution, such as of sodium hydroxide or potassium hydroxide, in the case where the template compound is a compound having an anchor group, for example a carboxyl group, a sulfonic acid group or a phosphoric acid group, but the means for desorbing the template compound is not limited to this, and an appropriate means can be used in accordance with the type of template compound. It is preferable to clean the substrate with alkaline of pH 9 to 13.

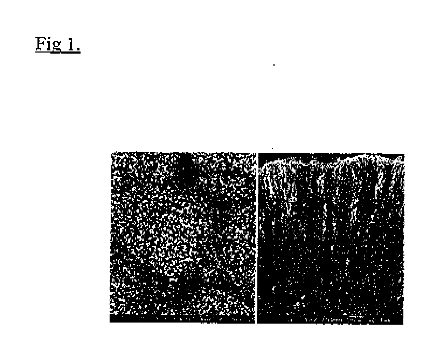

As a concrete example, Fig 1 is a microscope photograph showing a thin film of crystalline porous zinc oxide deposited by forming a hybrid thin film of zinc oxide/Eosin Y on an FTO glass substrate through cathodic polarization at a constant potential of -1.0 V (_{vs.} SCE) for 20 minutes at an electrode rotation speed of 500 rpm in a solution (70 °C) which includes 5 mM of ZnCl₂ + 0.1 M of KCl + 50 µM of Eosin Y and is saturated with oxygen, and after that, immersing the film in a diluted KOH solution having a pH of 10.5 so that Eosin Y molecules are removed. As is clear from this photograph, in the fabricated thin film of zinc oxide, porosity is not a result of microscopic particles aggregating, but wires of zinc oxide are regularly linked to each other so that a zinc oxide crystal having a size of several micrometers is formed as a whole, and thus, a thin film of crystalline porous zinc oxide having both a very large area and the high crystallinity required for fast charge transport can be provided.

(2) Modification of surface of thin film of crystalline porous zinc oxide with bridge ligands

Next, the surface of this thin film of crystalline porous zinc oxide is modified with bridge ligands. There are two methods for modifying the thin film of crystalline porous zinc oxide with bridge ligands. One is a method for immersing the thin film of crystalline porous zinc oxide in a bridge ligand solution so that the thin film adsorbs bridge ligands, and the other is a method for fabricating a hybrid thin film through cathodic polarization in a electrolytic bath for polarizing zinc oxide into which bridge ligands are mixed when the thin film of zinc oxide is fabricated.

(a) Method for immersion in bridge ligand solution for adsorption

It is desirable to use an organic molecule having two or more types of moieties that can be coordinated for a rare earth metal ion in one molecule as the bridge ligand, and a molecule which can form a compound of which the location of coordination can be selected in accordance with the type of rare earth metal ion with which the molecule coordinates is desirable. As an example of a preferable bridge ligand, dcbpy can be cited. In dcbpy, bipyridine, which is a chelate ligand, forms a stable complex compound with rare earth ions, but the stability when combined with zinc ions is relatively low, and the carboxyl group of the dcbpy has a high affinity with zinc ions, and therefore, the dcbpy can be selectively adsorbed on the surface of zinc oxide via a carboxyl group.

In order for the surface of the thin film of porous zinc oxide to be modified with bridge ligands, the thin film may be immersed in a solution in which bridge ligands are dissolved. The above described thin film substrate of porous zinc oxide is immersed in an ethanol solution of dcbpy, for example, and thus, the substrate can adsorb bridge ligands.

(b) Method for fabricating hybrid thin film through cathodic polarization

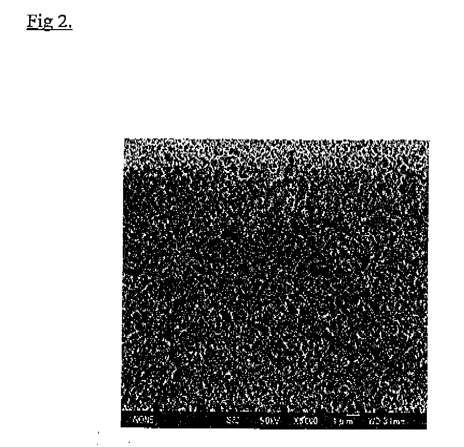

A hybrid thin film of a thin film of zinc oxide/bridge ligands can be fabricated through cathodic polarization in a electrolytic bath for zinc oxide into which bridge ligands are mixed at the fabrication of a thin film of porous zinc oxide. A case where dcbpy is modified is shown as a concrete example below. A three-electrode integrated cell having an FTO substrate, a zinc line, which is the counter electrode, and an SCE (saturated calomel electrode), which is a reference electrode, is electrolyzed in a solution 0.1 M of KCl, 5 mM ZnCl₂ and 200 µM dcbpy saturated with oxygen with a constant potential of -1.0 V _{vs.} SCE for 20 minutes, and thus, a thin film of a ZnO/dcbpy hybrid can be fabricated. A thin film having a porous structure as that shown in Fig 2 can be obtained through adsorption on the surface of dcbpy molecules.

(3) Adsorption of rare earth metal ions

When the hybrid thin film of a thin film of porous zinc oxide or a thin film of zinc oxide/bridge ligands on which dcbpy is adsorbed as described above is immersed in a rare earth metal ion solution, dcbpy molecules are chelate coordinated with rare earth metal ions via N atoms, and thus, the rare earth metal ion is adsorbed, so that a luminescent hybrids are formed on the surface and a luminescent layer is formed. It is considered that the thin film is immersed in, for example, an ethanol solution of EuCl₃, TbCl₃ and TmCl₃ for adsorption, and thus, Eu³⁺, Tb³⁺ and Tm³⁺ ions are adsorbed, so that a luminescent layer is formed.

The luminous device according to the present invention is fabricated as described above.

(4) Capping process

Furthermore, a capping ligand can be adsorbed in order to stabilize the complex in the luminous device. The capping ligand is provided so as to be coordinated with a rare earth metal and cover the rare earth metal complex, and thus, stabilize the complex, and may be a ligand having one or more moieties that can be coordinated. In the case where phenanthroline or 4,4,4-trifluoro-1-(2-thienyl)-1,3-butanedione (TTA) is used, for example, TTA can be appropriately adsorbed through immersion in an ethanol solution of 200 µM TTA at 80 °C for one hour. As a result, the intensity of luminescence can be increased, and at the same time, the luminescence properties can be prevented from worsening due to water in the air and the like, so that a luminescent device which is stable for a long period of time can be provided.

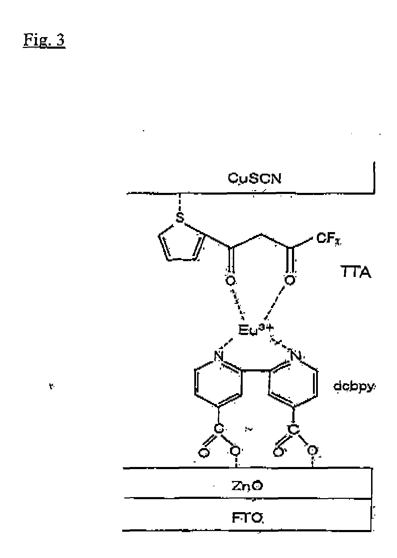

The fabricated luminescent device can be applied for EL. A p type semiconductor can be deposited on the surface layers of the above described luminescent device, that is to say, the thin film of porous zinc oxide which is modified with dcbpy and adsorbs a rare earth metal so that a metal complex is formed, or similar thin film which further adsorbs capping ligands, and thus, EL can be provided. For example, a layer of CuI, CuSCN, NiO or Cu₂O, which are p type semiconductors, can be formed through polarization, casting of a solution and exsiccation, and thus, an appropriate EL element can be fabricated. Fig 3 is a reference diagram showing the structure of an EL device made of an FTO electrode, a thin film of crystalline porous zinc oxide, dcbpy, Eu, TTA and CuSCN as one example of EL according to the present invention. Of course, this is merely a diagram showing one theoretical model. Naturally, the composition materials are not limited to these.

In the fabricated EL element, a thin film of crystalline porous zinc oxide, which is an N type semiconductor, functions as an electron transport layer, a P type semiconductor, for example Cul, CuSCN, NiO or Cu₂O, functions as a hole transport layer, and a metal complex formed of bridge ligands with which the electron transport layer is modified and a rare earth metal function as a luminescent layer.

An appropriate electrode is provided on the respective outer layers of the hole transport layer in this EL element so that EL is provided. The material for the electrodes is not limited, but various materials that have been developed according to the prior art can be used.

(Examples) In the following, examples of the luminescent device according to the present invention are shown together with the results of experiment.

### Example 1

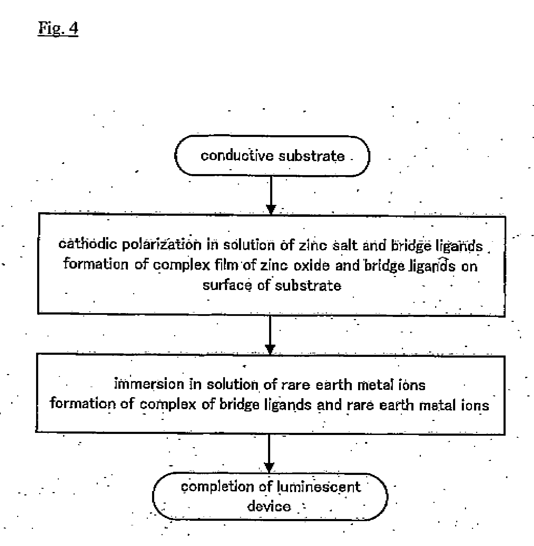

Fig 4 shows the flow of manufacture for the luminescent device according to the present example. An FTO substrate that was washed with ultrasonic waves in acetone, 2-propanol, a solution of 0.5 & bistre and distilled water for 15 minutes each, and after that, etching processed for 2 minutes with nitric acid of 45 % was used as the substrate. Then, this FTO substrate was used as an action electrode, a zinc line was used as the counter electrode, and an SCE was used as the reference electrode in a three-electrode integrated cell, where electrolysis was carried out in a solution of 0.1 KCl, 5 mM ZnCl₂ and 200 µM dcbpy, which was saturated with oxygen at a constant potential of E = -1.0 V vs SCE for 20 minutes so that a composite thin film of ZnO/dcbpy was fabricated. Here, the temperature of the bath was kept at 70 °C, and the action electrode was a rotational disc of which the number of rotations was 500 rpm. After that, the substrate was immersed in an ethanol solution of 1 mM EuCl₃ for 1 hour at 80 °C so that the substrate adsorbed rare earth metal ions, that is, Eu³⁺, and thus, a luminescent device was obtained.

The spectra of the dcbpy metal complex of Eu and Example 1 were respectively measured in FTIR in order confirm whether there was dcbpy electrically deposited on the luminescent device of Example 1 and adsorption of Eu into the zinc oxide thin film. The results are shown in Table 1.

[Table 1]
Data on Eu/dcbpy complex measured in FTIR 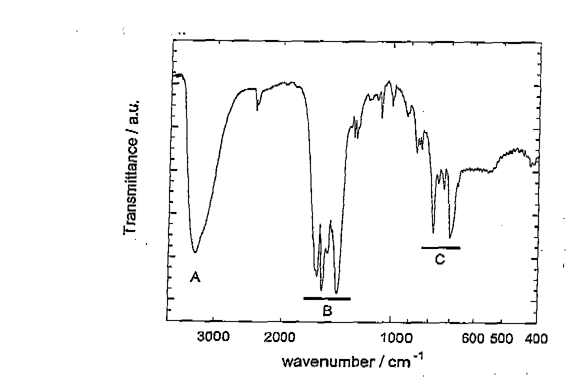 Data on Example 1 measured in FTIR

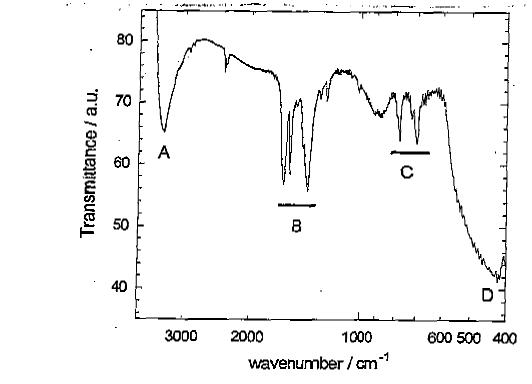

Table 1 shows the clear energy peaks of A, B and C, which are similar between the spectra of the dcbpy metal complex of Eu³⁺ and Example 1, and thus, shows that dcbpy is adsorbed by the thin film of crystalline porous zinc oxide. The three bands of approximately 1600 cm⁻¹, 1560 cm⁻¹ and 1400 cm⁻¹ in region B are caused by the contraction and expansion vibration of C=C, C=N and the carboxylic acid group (-CO₂-) in the dcbpy.

Table 2 shows excitation spectra and the luminescence spectra of the luminescent device of Example 1.

[Table 2]
Excitation spectrum and luminescent spectrum of luminescent device of Example 1

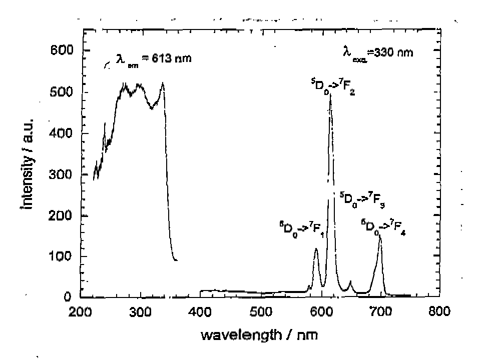

In Example 1, red luminescence, which is the most intense at 613 nm as a result of excitation by ultraviolet rays of 330 nm was confirmed. The luminescence had such intensity as to be clearly confirmable with the eye. The peak seen at 330 nm in the excitation spectrum measured with a monitor wavelength of 613 nm reflects the absorbing band of dcbpy, and it can be confirmed that the formation of a complex of dcbpy and Eu³⁺ caused an energy shift from dcbpy to Eu³⁺, as well as luminescence accompanying this.

Furthermore, the luminescent device of Example 1 was immersed in an ethanol solution of 200 µM TTA for one hour at 80 °C so that an adsorption process for TTA, which is a capping ligand, was carried out, so that measurement could be carried out to see the effects of capping. Table 3 shows the fluorescent spectra of a luminescent device where a capping process was carried out with TTA and a luminescent device which was not processed, as well as the fluorescent spectra of the two samples one month later.

[Table 3]
Luminescence spectra of sample of luminescent device of Example 1 in case where capping process was carried out with TTA and in case where unprocessed 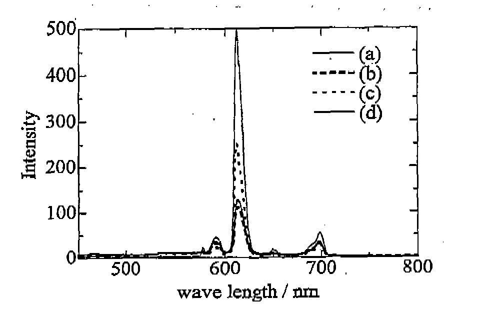
(a) Fluorescent spectrum of luminescent device of Example 1 in case where no TTA adsorption process was carried out
(b) Fluorescent spectrum of luminescent device of Example 1 in case where no TTA adsorption process was carried out after one month
(c) Fluorescent spectrum of luminescent device of Example 1 in case where TTA adsorption process was carried out
(d) Fluorescent spectrum of luminescent device of Example 1 in case where TTA adsorption process was carried out after one month

It was confirmed from Table 3 that the intensity of luminescent spectrum increased as a result of the capping process with TTA. This is considered to be an effect of the yield of luminescent quanta increasing when the ligand field of the Eu³⁺ complex was stabilized through coordination of TTA, and thus, it was confirmed that the complex was capped with TTA. Furthermore, when the luminescent spectra were compared after the samples were left in the air for one month, it was found from the gained results that the intensity of luminescence of the unprocessed sample slightly lowered, while the intensity of fluorescence of the sample where a TTA adsorption process was carried out became high. As a result, it was confirmed that the capping ligand contributed to the stabilization of the complex.

### Example 2

The luminescent device of Example 2 was obtained through adsorption of rare earth metal ions Tb³⁺ through immersion in an ethanol solution of 1 mM TbCl₃ for one hour at 80 °C instead of the ethanol solution of 1 mM EuCl₃ in Example 1.

Table 4 shows the excitation spectrum and the luminescence spectrum of the obtained luminescent device of Example 2.

[Table 4]
Excitation spectrum and luminescent spectrum of luminescent device of Example 2

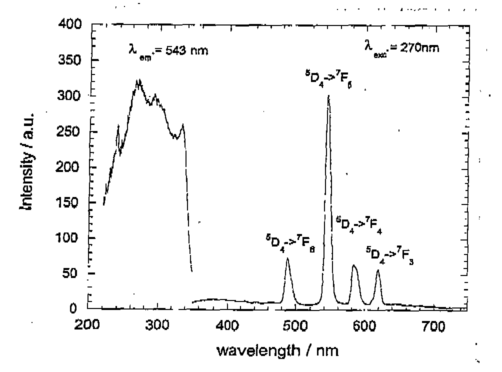

When Example 2 was excited with ultraviolet rays of 270 nm, green luminescence which was most intense at 543 nm was confirmed.

### Example 3

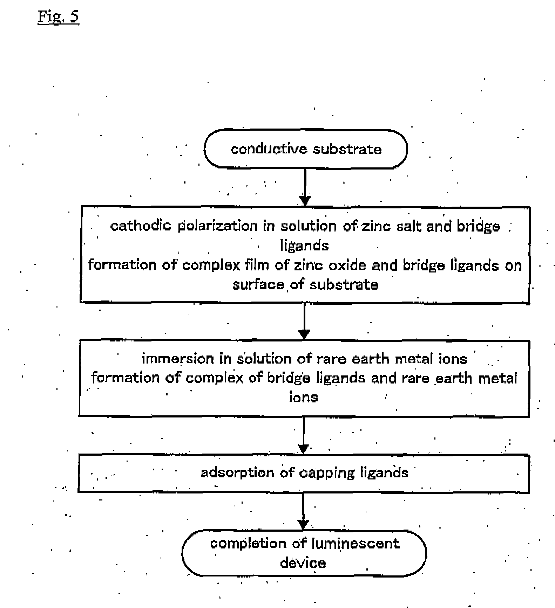

Fig 5 shows the flow of manufacture for the luminescent device according to the present example. The luminescent device of the present example was obtained through adsorption of rare earth metal ions Tb³⁺ through immersion in an ethanol solution of 3 mM TbCl₃ for one hour at 80 °C in addition to the ethanol solution of 1 mM EuCl₃ in Example 1.

The obtained luminescent device was further immersed in a solution of 1 mM phenanthroline for one hour, and thus, a luminescent device on which a capping process was carried out was obtained. Then, the spectra were measured for the luminescent device on which a capping process was carried out and the luminescent device on which no capping process was carried out. The results are shown in Table 5.

[Table 5]
Luminescence spectra of luminescent device of Example 3 and that of the device in which capping of phenanthroline was carried out to Example 3.

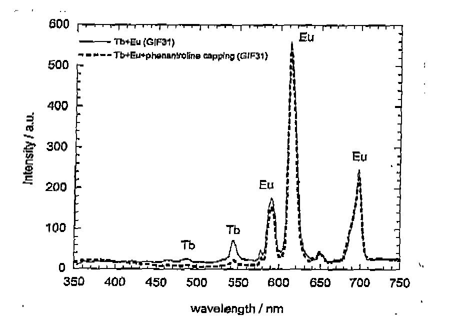

It was confirmed from Table 5 that there were luminescence peaks originating from both Eu and Tb, and it was confirmed that the color tone in luminescence could be changed by mixing different types of rare earth metal ions. It could not be confirmed that the luminous spectra improved greatly as a result of the capping process with phenanthroline.

After that, the luminescent device of Example 3 both in the case where a capping process was carried out and in the case where no capping process was carried out was left in the air, and the change in the relative intensity in the peak of luminescence of the Eu complex at 613 nm over time was measured. The results are shown in Table 6.

[Table 6]
Graph showing change in relative intensity at peak of luminescence of Eu complex at 613 nm over time after leaving in the air the luminescent device of Example 3 in case where no capping process was carried out and in case where capping process was carried out.

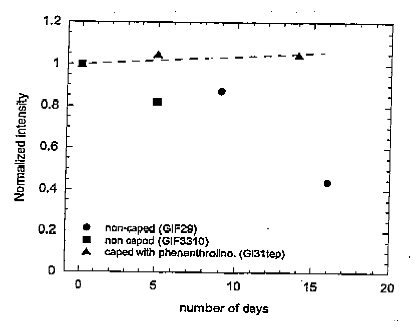

It can be confirmed from Table 6 that the intensity of luminescence of the luminescent devices on which no capping process was carried out decreased to approximately 90 % of the original intensity of luminescence after 10 days and to slightly over 40 % after 16 days, while the intensity of luminescence of the luminescent device on which a capping process was carried out was stable. That is to say, it was found that a capping process contributed to prevention of the luminous properties from deteriorating due to oxygen and water.

### Example 4

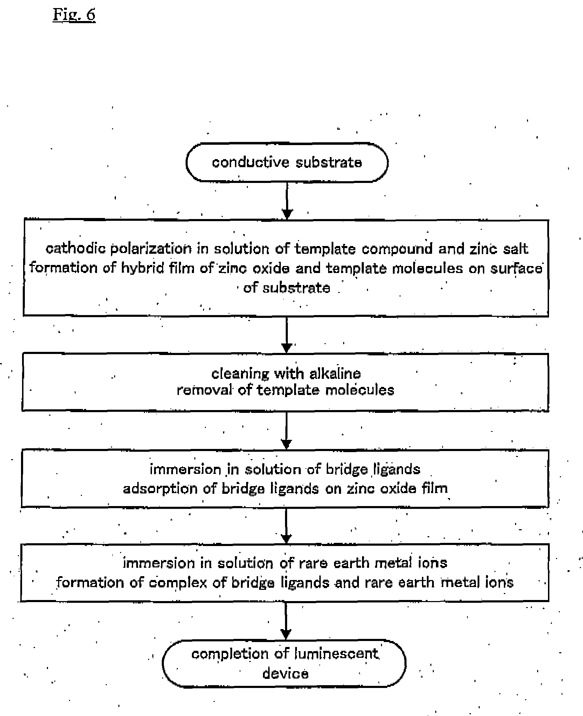

Fig. 6 shows the flow of manufacture for the luminescent device according to the present embodiment. The thin film of crystalline porous zinc oxide in the luminescent device of the present example was obtained by cathodic polarization of the substrate in an electrolytic solution containing zinc salt and template molecules. An FTO substrate which was washed with ultrasonic waves in acetone, 2-propanol, a solution of 0.5 % bistre and distilled water for 15 minutes each, and after that, etching processed with 45 % nitric acid for 2 minutes was used as the substrate. Then, this FTO substrate was used as an action electrode, a zinc line was used as the counter electrode, and SCE was used as the reference electrode in a three-electrode integrated cell where electrolysis was carried out in a solution of 0.1 KCl, 5 mM ZnCl₂ and 200 µM Eosin Y, which is template molecules, which was saturated with oxygen for 20 minutes at a constant potential E = -1.0 V vs. SCE so that a thin film of a ZnO/Eosin Y composite was fabricated. Here, the temperature of the bath was kept at 70 °C and the action electrode was a rotational disc of which the number of rotations was 500 rpm. The fabricated thin film of a ZnO/Eosin Y composite was immersed in a KOH solution of which the pH was adjusted to 10.5 so that the dye was desorbed, and thus, a thin film of crystalline porous zinc oxide was obtained. The obtained thin film of crystalline porous zinc oxide was immersed in an ethanol solution of 200 µM dcbpy so that bridge ligands were adsorbed, and after that, immersed in an ethanol solution of 1 mM EuCl₃ for one hour at 80 °C, so that the thin film adsorbed rare earth metal ions Eu³⁺, and thus, the luminescent device of Example 4 was gained.

In order to confirm whether or not there was dcbpy electrically deposited on the luminescent device of Example 4 and the ions were adsorbed by the thin film of crystalline porous zinc oxide, spectra were measured in FTIR for the respective samples of the thin film of crystalline porous zinc oxide, the thin film of crystalline porous zinc oxide which was immersed in an ethanol solution of 200 µM dcbpy so that the bridge ligands were adsorbed, and Example 4. The results are shown in Table 7.

[Table 7]
Spectra of thin film of crystalline porous zinc oxide, dcbpy adsorbing thin film of crystalline porous zinc oxide and Example 4 in FTIR 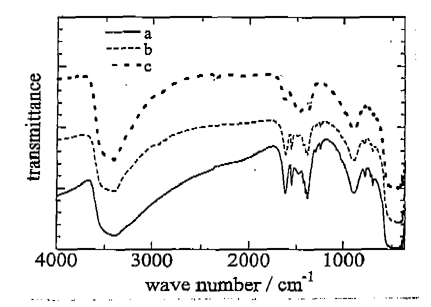
(a) dcbpy adsorbing thin film of crystalline porous zinc oxide (no Eu adsorption)
(b) Example 4
(c) thin film of crystalline porous zinc oxide

The three bands between approximately 1400 cm⁻¹ to 1600 cm⁻¹ are caused by the contraction and expansion vibration of C=C, C=N and the carboxylic acid group (-CO₂-) in the dcbpy. Peaks were confirmed in each of the samples of the thin film of crystalline porous zinc oxide which was immersed in an ethanol solution of 200 µM dcbpy so that bridge ligands were adsorbed and Example 4, and therefore, it was confirmed that adsorption of dcbpy was possible through immersion of a thin film of porous zinc oxide in an ethanol solution of dcbpy. In addition, it was confirmed that the dcbpy was not removed even after the adsorption process of Eu³⁺.

Next, Table 8 shows the luminescence spectra of Example 4.

[Table 8]
Luminous spectra of Example 4 and Example 5 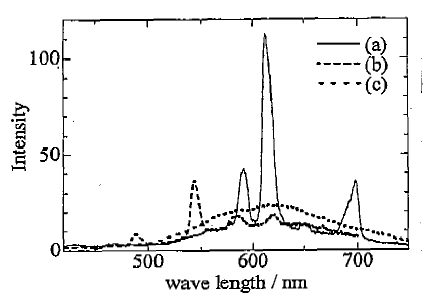
(a) Example 4
(b) Example 5
(c) (Reference) thin film of porous ZnO which was immersed in EtOH solution of 1 mM EuCl₃ for one hour at 80 °C (no modification with dcbpy)

### Example 5

The luminescent device of Example 5 was gained through adsorption of rare earth metal ions Tb³⁺ through immersion in an ethanol solution of 1 mM TbCl₃ for one hour at 80 °C in Example 4.

Table 8 shows the luminescence spectrum of Example 5. It was confirmed from Table 8 that the luminescent device which adsorbed Eu³⁺ and Tb³⁺ exhibited luminescence. In addition, Examples 4 and 5 both have three peaks, which are spectra specific to dcbpy complexes, and therefore, it was confirmed that a complex was formed on the thin film of crystalline porous zinc oxide which adsorbed dcbpy, by immersing the thin film in an ethanol solution of a rare earth metal. In addition, the sample gained by immersing a thin film of porous zinc oxide without carrying out a dcbpy process in an EuCl₃ solution did not have any luminescence. It was confirmed that use of bridge ligands was essential for the formation of a luminescent rare earth metal complex.

### Example 6

Next, the luminescent device of example 1 was used and electrolysis was carried out in an ethanol solution of 0.1 M Cu(ClO₄)₂ and 0.025 M LiSCN for 20 minutes at a potential for electrocrystallization E = +0.2 V vs. Ag/AgCl using a three-electrode integrated cell so that CuSCN, which is a p-type semiconductor and works as a hole transport layer, was deposited. The action electrode was the luminescent device of Example 1, which was used as a rotating electrode at 500 rpm. A Pt line was used for the counter electrode, and the temperature of the bath was 15 °C. After the polarization of CuSCN, Au was vapor-deposited on the surface. A voltage of 10 V was applied with an FTO substrate as a cathode and Au as an anode. Then, the same luminescence as in the luminescent device of Example 1 was confirmed.

Though concrete embodiments of the present invention are described in detail in the above, these are merely illustrative, and do not limit the claims. The technology described in the claims includes numerous variations and modifications of the above illustrated embodiments. For example, though luminescent devices having a luminescent portion where a metal complex formed of a bridge ligand and a rare earth metal is applied are described in the embodiments, it is also possible to apply a complex of a bridge ligand and a transition metal or a typical metal, such as Zn, Be, Al or Ir, in the luminescent portion. In addition, it is also possible to apply luminescent organic molecules in the luminescent portion. Industrial Applicability

The luminescent device according to the present invention can be used in photoluminescence (PL) through excitation by light, electroluminescence (EL) through excitation by an electrical field, cathode luminescence (CL) through excitation by an electron beam and the like, and thus, application in self-illuminating displays, lighting apparatuses and the like is possible.

### Brief Description of the Drawings

Fig. 1 is a microscope photograph showing crystalline porous zinc oxide from which template molecules have been removed from a crystalline porous zinc oxide/template molecule hybrid;
Fig. 2 is a microscope photograph showing a state where dcbpy molecules are adsorbed on the surface of a ZnO/dcbpy hybrid thin film;
Fig. 3 is a reference diagram showing the basic structure of the luminescent device according to the present invention in the case where a thin film of porous zinc oxide, dcbpy, which is a bridge ligand, Eu³⁺, which is a rare earth metal, and CuSCN, which forms a hole transport layer, are used;
Fig. 4 is a flow chart showing the manufacturing process for the luminescent device of Example 1;
Fig. 5 is a flow chart showing the manufacturing process for the luminescent device of Example 3; and
Fig. 6 is a flow chart showing the manufacturing process for the luminescent device of Example 4.

## Claims

1. A luminescent device, comprising:
a matrix containing crystalline porous zinc oxide as a main component, and functioning as an electron transport layer; and
a luminescent element comprising a metal complex formed of a modified bridge ligand and a rare earth metal on a surface of said matrix.

2. The luminescent device of claim 1, wherein said crystalline porous zinc oxide comprises zinc oxide which is electrodeposited on a conductive substrate by cathodic polarization of the said conductive substrate in an electrolytic solution containing zinc salt.

3. The luminescent device of claim 1, wherein said crystalline porous zinc oxide comprises zinc oxide formed through the steps of: depositing a zinc oxide/template molecule hybrid on a conductive substrate by cathodic polarization of the said conductive substrate in an electrolytic solution containing zinc salt into which a template compound having adsorptivity for zinc oxide is mixed; and removing template molecules from said zinc oxide/template molecule hybrid.

4. The luminescent device of claim 1, wherein said bridge ligand comprises organic molecules having at least two parts exhibiting ligating properties for metal ions in one molecule and forming a coordination compound regioselective corresponding to the type of rare earth metal ion.

5. The luminescent device of claim 1, wherein said bridge ligand is selected from the group consisting of 2,2'-bipyridine 4,4-dicarboxylic acid, phenanthroline, 1,0-phenanthroline-4,7-dicarboxylic acid, 2,2';6',2"-terpyridine-4'-carbonxylic acid, 2,2';6',2"-terpyridine, 4,4',4"-tricarboxylic acid, 2,2'-biquinoline-4,4' dicarboxylic acid, 4-quinolinecarboxylic acid, 2-(4-carboxy-2-pyridinyl), dibenzo [b,j] [1,10] phenanthroline-5,B-dicarboxylic acid and combinations of these.

6. The luminescent device of claim 1, wherein said rare earth metal is selected from the group consisting of Eu, Tb, Tm, Ce and combinations of these.

7. The luminescent device of any of claims 1-6, wherein a surface of said luminescent element made of a metal complex is capped with a ligand forming a complex with said rare earth metal.

8. The luminescent device of claim 7, wherein said ligand is at least one selected from a β-diketone group shown in the general formula R¹COCR²COR³, wherein R¹ and R³ represent an alkyl group with a carbon number of 1-20, a halogenated alkyl group with a carbon number of 1-20, an aryl group with a carbon number of 6-20, a 5 or 6-member heterocyclic group having one hetero atom or a carboxyl group, and R² represents a hydrogen atom, a halogen atom, a cyano group, an alkyl group with a carbon number of 1-20, a halogenated alkyl group with a carbon number of 1-20, an aryl group with a carbon number of 6-20 or a 5 or 6-member heterocyclic group having one hetero atom.

9. The luminescent device of claim 7, wherein said ligand is selected from the group consisting of 4,4,4-trifluoro-1-(2-thienyl)-1, butanedione, 1,10-phenanthroline and derivatives of these, 2,2'-bipyridine and derivatives thereof, 2,2';6',2"-terpyridine and derivatives thereof, and combinations of these.

10. An electroluminescent device, comprising;
an electron transport layer having an n-type semiconductor containing a thin film of crystalline porous zinc oxide as a main component;
a luminescent layer comprising a metal complex formed of a modified bridge ligand and a rare earth metal on said electron transport layer;
a hole transport layer having a p-type semiconductor containing an inorganic compound; and
an electrode layer provided on the outer layers of said hole transport layer and said electron transport layer.

11. The electroluminescent device of claim 10, wherein said crystalline porous zinc oxide comprises zinc oxide which is electrodeposited on a conductive substrate by cathodic polarization of the said conductive substrate in an electrolytic solution containing zinc salt to reduce oxygen dissolved in said zinc salt solution.

12. The electroluminescent device of claim 10, wherein said crystalline porous zinc oxide comprises zinc oxide formed through the steps of: depositing a zinc oxide/template molecule hybrid on a conductive substrate by cathodic polarization said conductive substrate in an electrolytic solution containing zinc salt into which a template compound having adsorptivity for zinc oxide is mixed; and removing template molecules from said zinc oxide/template molecule hybrid.

13. The electroluminescent device of claim 10, wherein said bridge ligand comprises organic molecules having at least two parts exhibiting ligating properties for metal ions in one molecule and forming a coordination compound regioselective corresponding to the type of rare earth metal ion.

14. The electroluminescent device of claim 10, wherein said bridge ligand is selected from the group consisting of 2,2'-bipyridine 4,4-dicarboxylic acid, phenanthroline, 1,10-phenanthroline-4,7-dicarboxylic acid, 2,2';6',2"-terpyridine-4'-carbonxylic acid, 2,2';6',2"-terpyridine, 4,4',9"-tricarboxylic acid, 2,2'-biquinoline-4,4' dicarboxylic acid, 4-quinolinecarboxylic acid, 2-(4-carboxy-2-pyridinyl), dibenzo [b, j] [1, 10] phenanthroline-5, 8-dicarboxylic acid and combinations of these.

15. The electroluminescent device of claim 10, wherein said rare earth metal is selected from the group consisting of Eu, Tb, Tm, Ce and combinations of these.

16. The electroluminescent device of any of claims 10 to 15, wherein a surface of said luminescent element made of a metal complex is capped with a ligand forming a complex with said rare earth metal.

17. The electroluminescent device of claim 15, wherein said ligand is at least one selected from a β-diketone group shown in the general formula R¹COCR²COR³, wherein R¹ and R³ represent an alkyl group with a carbon number of 1-20, a halogenated alkyl group with a carbon number of 1-20, an aryl group with a carbon number of 6-20, a 5 or 6-member heterocyclic group having one hetero atom or a carboxyl group, and R² represents a hydrogen atom, a halogen atom, a cyano group, an alkyl group with a carbon number of 1-20, a halogenated alkyl group with a carbon number of 1-20, an aryl group with a carbon number of 6-20 or a 5 or 6-member heterocyclic group having one hetero atom.

18. The electroluminescent device of claim 15, wherein said ligand is selected from the group consisting of 4,4,4-trifluoro-1-(2-thienyl)-1,3-butanedione, 1,10-phenanthroline and derivatives of these, 2,2'-bipyridine and derivatives thereof, 2,2';6',2"-terpyridine and derivatives thereof, and combinations of these.

19. The electroluminescent device of claim 10, wherein said hole transport layer is selected from the group consisting of CuI, CuSCN, NiO, Cu₂O and combinations of these.
